# EUROPÄISCHE PATENTSCHRIFT

(11) **EP 0 740 865 B1**
(45) Veröffentlichungstag und Bekanntmachung des Hinweises auf die Patenterteilung: **18.10.2000**
(21) Anmeldenummer: 95906244.9
(22) Anmeldetag: 16.01.1995
(51) Int. Cl.: H04H 1/00

(54) **VERFAHREN UND EMPFÄNGER ZUR ERMITTLUNG DER EMPFANGBARKEIT VON FUNKSIGNALEN IN EINEM FUNKSYSTEM**
PROCESS AND RECEIVER FOR FINDING THE RECEIVABILITY OF RADIO SIGNALS IN A RADIO SYSTEM
PROCEDE ET APPAREIL POUR DETERMINER LES SIGNAUX RADIO POUVANT ETRE RECUS DANS UN SYSTEME RADIO

(30) Priorität: 19.01.1994 DE 4401460
(43) Veröffentlichungstag der Anmeldung: 06.11.1996
(73) Patentinhaber: FRAUNHOFER-GESELLSCHAFT ZUR FÖRDERUNG DER ANGEWANDTEN FORSCHUNG E.V., 80636 München (DE); Institut für Rundfunktechnik GmbH, 80939 München (DE)
(72) Erfinder: GERHÄUSER, Heinz, D-91344 Waischenfeld (DE); SEITZER, Dieter, D-91054 Erlangen (DE); PLENGE, Georg, D-82544 Egling-Thanning (DE); SEDLMEYER, Robert, D-85737 Ismaning (DE)
(86) Internationale Anmeldenummer: DE9500055
(87) Internationale Veröffentlichungsnummer: WO9520276

(56) Entgegenhaltungen:
- EP-A- 0 072 943
- EP-A- 0 387 810
- DE-A- 3 040 465

## Beschreibung

### Technisches Gebiet

Die Erfindung betrifft ein Verfahren zur Ermittlung der Empfangbarkeit von Funksignalen in einem Funksystem und einen Empfänger zum Durchführen der empfangsseitigen Maßnahmen.

Insbesondere findet die Erfindung Anwendung in einem Rundfunksystem, vor allem einem Gleichwellensystem, wobei die Funksignale etwa die empfangbaren Sender, Programmsignale und/oder Programmsparten umfassen. Denn beim Empfang von Rundfunksendern mit mobilen Empfängern, z. B. in einem Kraftfahrzeug, sind gewünschtermaßen am jeweiligen aktuellen Empfangsort die empfangbaren Programme zu ermitteln. Dazu gehören beispielsweise Informationen zur Straßenverkehrslage oder Informationen im Rahmen eines Verkehrsleitsystems.

### Stand der Technik

Die heutigen analogen UKW-Übertragungsverfahren reagieren empfindlich auf Feldstärkeschwankungen und Mehrwegeempfang, deren Auswirkungen nur zum Teil durch beispielsweise aufwendige Umschaltstrategien auf sogenannte alternative Frequenzen, die im Rahmen der Radio-Daten-Signale (ROS-Signale) ausgesandt werden, vermindert werden können. Eine Standortbestimmung eines mobilen Empfängers ist bisher mit einem hohen Aufwand verbunden. So werden komplexe Schaltungsanordnungen, oftmals sogar mit zwei Empfangsteilen, Referenzsender und/oder im Empfänger gespeicherte Listen alternativer Frequenzen benötigt. Letzteres deshalb, um möglichst verzögerungsfrei und unhörbar auf alternative Frequenzen umschalten zu können, falls bei einem Programmabruf der Muttersender nicht oder nur mit schlechter Qualität empfangbar bzw. empfangswürdig ist. Abhängig vom aktuellen Empfangsort Informationen über empfangbare Programme ausgewiesen zu bekommen, ist mit den bestehenden Systemen, z. B. dem erwähnten RDS, nur sehr eingeschränkt möglich. Zudem erfordern die durchgeführten Suchläufe zur Feststellung empfangbarer Sender und deren Indentifikation vergleichsweise viel Zeit.

Aus der DE 41 07 116 ist ein Verfahren zur Standortbestimmung eines mobilen Funkempfängers bekannt, das die Radio-Daten-Signale wenigstens dreier ortsfester Sender zur passiven Auswertung verwendet. Es wird in dieser Druckschrift darauf hingewiesen, daß das Verfahren die Möglichkeit bietet, die bestimmten Standort-Koordinaten des mobilen Funkempfängers mit streckenspezifischen und/oder geographischen Kennungen von über das RDS-Signal im Traffic-Message-Channel übertragenen Verkehrsnachrichten zu verknüpfen. Dadurch werden aus den übertragenen Verkehrsnachrichten diejenigen selektiert, die für den augenblicklichen Standort von Bedeutung sind, und alle übrigen ausgeblendet. Nachteilig ist, daß der Benutzer die jeweilige Programmsparte, hier Verkehrsnachrichten, vorwählen muß und er somit vor seiner Vorwahl keine Kenntnis darüber besitzt, ob er überhaupt etwas empfangen wird und was es gegebenenfalls sein wird. Es wird demzufolge länger dauern, bis der Benutzer nach einem oder mehreren Suchvorgängen die gewünschten Informationen auch tatsächlich empfängt.

Um eine qualitativ hochwertige Hörfunkübertragung, die dem von digitalen Speichermedien (z. B. DAT) gebotenen Qualitätsstandard entspricht, zu erhalten, wurde ein Standard für ein terrestrisches, digitales Übertragungsverfahren unter dem Namen DAB (Digital Audio Broadcasting) erarbeitet. Eines der wesentlichen Kennzeichen des DAB-Verfahrens ist der Gleichwellenbetrieb der für ein Empfangsgebiet eingesetzten Sender, wonach alle diese Sender frequenz- und phasenstarr gekoppelt sind und die Modulationsinhalte der einzelnen Träger für alle Sender identisch sind. Aus der DE 42 23 194 ist bekannt, daß ein für DAB geeigneter Empfänger auch gleichzeitig zur Standortbestimmung mitbenutzt werden kann, so daß keine zusätzlichen Empfänger benötigt werden. Auch zusätzliche Sender sind nicht erforderlich.

In der DE 42 22 877 wird darüber hinaus ausgeführt, wie in einem DAB-Netz mit technischen Mitteln regional oder lokal unterschiedliche Informationen übertragen werden können, ohne die Übertragung lokal nicht unterschiedlicher Informationen, die im Gleichwellenbetrieb erfolgt, zu stören. Die Übertragung der regional verschiedenen Informationen erfolgt insbesondere durch zusätzliches senderseitiges Aussenden von Einzelträgerfrequenzen, die vorzugsweise in einem Zeitschlitz eines Übertragungsrahmens übertragen werden, der auch zur Synchronisation des Empfängers benutzt wird. Der Empfänger zum Durchführen der empfangsseitigen Maßnahmen weist einen Speicher und eine Anzeige auf, wobei im Speicher zusätzliche Informationen mittels eines jedem Sender zugeordneten Datensatzes abgespeichert sind. Sie können teils auf der Anzeige ausgegeben werden oder sollen es dem Benutzer des Empfängers ermöglichen, durch Veränderung von Empfangsparameter z. B. die Empfangsqualität zu verbessern. Diese Druckschrift gibt nur Auskunft darüber, wie regional begrenzte Informationen innerhalb eines DAB-Netzes mit technischen Mitteln übertragen werden können.

Dem in der EP-A- 0 387 810 beschriebenen Verfahren liegt ein Empfangsgebiet zugrunde, bei welchem mehrere Sender mit derselben Sendefrequenz vorhanden sind und bei welchem in vorbestimmten Teilgebieten des Empfangsgebietes die jeweils dort empfangbaren Sendefrequenzen bekannt sind. Es geht in dieser Schrift darum, die von einem mobilen Empfänger momentan empfangene Frequenz der zugehörigen Sendeanstalt *eindeutig* zuordnen und somit den Namen dieser Sendeanstalt auf einem Display anzeigen zu können. Es wird also bereits ein Programm auf der empfangenen Frequenz empfangen, es ist nur noch nicht bekannt, von welcher Sendeanstalt das Programm ausgestrahlt wird. Um den Namen der Sendeanstalt angeben zu können, werden vom Empfänger *am aktuellen Empfangsort* die empfangbaren Sendefrequenzen in einem Suchlauf bestimmt. Dieses aktuelle Sendefrequenzprofil wird mit der im Empfänger abgespeicherten Tabelle, welche die den Teilgebietsnamen zugeordneten in dem jeweiligen Teilgebiet empfangbaren Sendefrequenzen enthält (Seite 3, Zeilen 6,7; Tabelle auf Seite 3), verglichen und daraus dasjenige Teilgebiet bestimmt, in dem sich der mobile Empfänger aktuell befindet. Aus einer weiteren Tabelle, die eine Zuordnung der Sendefrequenzen, der Teilgebiete und der Sendeanstaltsnamen enthält (Seite 4, Zeilen 32 bis 34), wird mit der bekannten, aktuell empfangenen Sendefrequenz und dem zuvor bestimmten Teilgebiet der zugehörige Sender identifiziert und dann dessen Namen neben der empfangenen Sendefrequenz und dem Teilgebietsnamen auf einem Display dem Benutzer angezeigt. Für die übrigen am aktuellen Empfangsort empfangbaren Sendefrequenzen wird weder die möglicherweise notwendige Identifizierung der zugehörigen Sendeanstalt vorgenommen noch die Sendefrequenzen selbst oder gar der Sendeanstaltsname auf der Anzeige dargestellt. In einer besonderen Ausführungsform des mobilen Empfängers wird die notwendige Bestimmung des Teilgebietes, in dem sich der mobile Empfänger gerade befindet dadurch bewerkstelligt daß bei Änderung des Programms bei gleicher empfangener Sendefrequenz und bei zuvor bekanntem Teilgebietsstandort auf Eingabe des Benutzers, in welche Himmelsrichtung er fährt, das neue Teilgebiet bestimmt wird.

### Darstellung der Erfindung

Ausgehend von dem oben dargelegten Stand der Technik, liegt der Erfindung die Aufgabe zugrunde, ein Verfahren und einen Empfänger zur Ermittlung der Empfangbarkeit von Sendern, Programmsignalen und/oder Programmsparten in einem Rundfunksystem, insbesondere in einem Gleichwellensystem, derart anzugeben, daß an jedem beliebigen Ort innerhalb eines Empfangsgebietes das vom Benutzer gewünschte Programm und/oder die gewünschte Programmsparte schnell und sicher auf seinem Empfänger aufschaltbar ist.

Diese Aufgabe wird durch die kennzeichnenden Merkmale des Anspruchs 1 und des Anspruchs 25 gelöst. Bevorzugte Weiterbildungen sind in den abhängigen Ansprüchen aufgeführt.

Die Erfindung stellt ein Verfahren und einen Empfänger zur Durchführung dieses Verfahrens bereit, mit dem in einem von einem oder mehreren Sendern eines Funksystems versorgten Empfangsgebiet an jedem beliebigen Ort Informationen über empfangbare Sender, Programmsignale und/oder Programmsparten ermittelt und dem Benutzer zur Auswahl angeboten werden.

Das vom Benutzer daraufhin ausgewählte Funksignal wird unmittelbar auf seinen Empfänger aufgeschaltet und steht so für weitere Verwendungszwecke am aktuellen Empfangsort zur Verfügung. Etwa für die Aktualisierung und/oder Ergänzung von Daten, welche im Empfangsgerät selbst oder auf einem Datenträger (z. b. Chipkarte), der mit dem Empfangsgerät verbunden ist oder zur Datenaktualisierung erst mit dem Empfangsgerät verbunden wird, gespeichert sind. In einem Ausführungsbeispiel der Erfindung in einem Rundfunksystem besteht der weitere Verwendungszweck des ausgewählten Funksignals, z. B. eines Programmes, in erster Linie darin, das auf das Empfangsgerät aufgeschaltete Programm dem Benutzer über Lautsprecher hörbar zu machen. Die Ausgabe von Bildinformationen, z. B. Landkarten, auf einem Display ist eine weitere vorkommende Verwendungsart.

Die Erfindung dient insbesondere zur Ermittlung der Empfangbarkeit von Sendern, Programmsignalen und/oder Programmsparten und gegebenenfalls weiteren Funksignalen in einem Rundfunksystem. Die Sender arbeiten dabei vorzugsweise im Gleichwellenbetrieb und können sowohl auf der Erde als auch außerhalb, etwa in Satelliten, stationiert sein. Die Programmsignale umfassen neben Tonprogrammen wahlweise auch Datenprogramme. Programmsparten bezeichnen Programmsorten, wie etwa Popmusik, Sport oder klassische Musik, die unabhängig davon sind, von welchen Sendern oder welcher Senderkette (z. B. Bayern 3) die Programme einer Programmsparte ausgestrahlt werden. Zur genauen oder angenäherten Bestimmung des Empfangsortes werden bekannte Verfahren, etwa aus der Rundfunktechnik, oder Satellitennavigationssysteme benutzt. Ein beispielsweise für ein DAB-Rundfunksystem geeignetes Ortsbestimmungsverfahren, das zur Auswertung eine Phasenvergleichs-Hyperbelverfahren benutzt, ist in der DE 42 23 194 beschrieben.

Es ist vorteilhaft an einem beliebigen Ort innerhalb des Empfangsgebietes insbesondere die sicher empfangbaren Sender, Programmsignale und/oder Programmsparten zu ermitteln. Denn diese sind durch die Sendeleistung der einzelnen Sender und deren Standorte von vornherein festlegbar, während etwa der Überreichweitenempfang sich infolge unterschiedlicher Wetterverhältnisse oder auch der Sonnenfleckenaktivität unkontrolliert zu ändern vermag.

Die Stationierung der Sender sowie die Festlegung ihrer Sendeleistungen erfolgt so, daß das Empfangsgebiet vorzugsweise in mehrere Teilgebiete so aufteilbar ist daß für jedes dieses Teilgebiete an jedem Ort dieselben sicher empfangbaren Sender, Programmsignale und/oder Programmsparten empfangbar sind und somit für jedes Teilgebiet eine einzige Liste über Informationen der sicher empfangbaren Sender, Programmsignale und/oder Programmsparten ausreicht. Diese lokalen Listen, im folgenden auch B-Listen genannt, werden von den Sendern übertragen, wobei dies vorzugsweise dadurch geschieht, daß alle lokalen B-Listen hintereinander angeordnet werden und die so entstehende B-Listen-Folge von allen Sendern ausgestrahlt wird. In einer speziellen Ausführungsform der Erfindung sind die B-Listen im Empfänger gespeichert, und es werden von den Sendern nur noch Informationen über vorzunehmende Änderungen an den im Empfänger abgespeicherten B-Listen übertragen. Diese Änderungen betreffen etwa vergleichsweise kurzfristige Programmänderungen. Bis auf Übertragungsfehler bei den übertragenen Aktualisierungsinformationen für die B-Listen ist die Speicherung der B-Listen fehlerfrei, woraus eine erheblich größere Sicherheit für den Benutzer resultiert.

Neben den B-Listen wird eine Liste A verwendet, welche die Kennungen aller im Empfangsgebiet prinzipiell empfangbaren Sender, Programmsignale und/oder Programmsparten enthält. Diese Liste A wird von allen Sendern ausgestrahlt. Bei einer weiteren Ausführungsform der Erfindung wird die Liste A im Empfänger gespeichert, am besten in einem externen Massenspeicher. Prinzipiell empfangbar bedeutet insbesondere, daß die Liste A so ausgebildet ist, daß auch für bereits stationierte aber noch nicht sendende Sender oder auch für erst in Planung befindliche Sender entsprechende Freiplätze in der Liste A vorgesehen sind. Wird etwa ein neuer Sender im Sendernetz hinzugeschaltet oder ein alter Sender abgeschaltet, so wird die Liste A entsprechend aktualisiert. In der zuvor genannten Ausführungsform einer im Empfänger gespeicherten Liste A sind dann nur diese Änderungen zu übertragen. Änderungen in der Liste A kommen in eher größeren Zeitabständen vor, wohingegen sich in den B-Listen die kurzfristigen Änderungen von z. B. Programmen auswirken.

Aus den B-Listen, insbesondere der B-Listen-Folge, wird mit den bestimmten Ortskoordinaten des Empfangsortes bzw. einer Ortsinformation über das zugehörige Teilgebiet die für den Empfangsort gültige B-Liste ausgewählt. Mit dieser lokalen B-Liste werden dann aus der Liste A die zugehörigen Kennungen der Sender, Programmsignale und/oder Programmsparten ausgewählt und dem Benutzer bzw. Hörer auf einer Anzeige oder durch eine Sprachausgabe zur Auswahl bereitgestellt. Der Benutzer hat nun Kenntnis über die an seinem aktuellen Empfangsort empfangbaren Sender, Programmsignale und/oder Programmsparten und kann seinem Wunsch gemäß einen bestimmten Sender und/oder ein bestimmtes Programm und/oder eine spezielle Programmsparte auswählen. Nach seiner Auswahl wird das Gewünschte unmittelbar auf seinen Empfänger aufgeschaltet.

Bei einem Rundfunksystem, wie etwa dem DAB, bei dem mehrere Frequenzblöcke mit einer bestimmten Bandbreite frequenzmäßig nebeneinander ausgesendet werden und ein Empfänger voraussichtlich nur in der Lage sein wird, einen einzigen solchen Frequenzblock zu einem Zeitpunkt zu empfangen, muß dafür Sorge getragen werden, daß einem solchen Empfänger nicht nur der Programminhalt dieses Frequenzblockes bekannt ist, sondern auch die Programminhalte anderer benachbarter Frequenzblöcke. Dies geschieht in den lokalen B-Listen durch die Verwendung von Informationen über empfangbare Sender, Programmsignale und/oder Programmsparten, welche auch in anderen Frequenzbereichen, Kanälen oder Frequenzblöcken empfangbar sind. So wird garantiert, daß der Benutzer die an seinem Empfangsort empfangbaren Sender, Programmsignale und/oder Programmsparten zur Auswahl angezeigt bekommt. Von besonderem Vorteil ist, daß dazu kein Verstimmen des Empfängers erforderlich ist und das Anzeigen der empfangbaren Sender, Programmsignale und/oder Programmsparten in einer kürzeren Zeitspanne erfolgt. Umgekehrt sind bei einer gleichbleibenden Zeitdauer für das Anzeigen dem Benutzer mehr Programme anbietbar.

In einer besonderen Ausführungsform der Erfindung wird am aktuellen Empfangsort nicht nur die zu diesem Ort bzw. seines Teilgebietes gültige B-Liste ausgewählt und im Empfänger gespeichert, sondern auch die B-Listen der angrenzenden Teilgebiete. Wird der Empfangsort nun gewechselt, so wird am neuen Empfangsort dieselbe Situation mit den gespeicherten B-Listen der unmittelbar angrenzenden Teilgebiete hergestellt. Die B-Listen der bezüglich des neuen Empfangsortes nicht mehr benachbarten Teilgebiete werden im Speicher gelöscht und die B-Listen der neu hinzugekommenen Nachbarteilgebiete werden im Speicher hinzugefügt. Das Mitabspeichern der B-Listen benachbarter Teilgebiete hat den Vorteil, daß unter Ausnutzung der Richtungsinformation des sich ändernden Empfangsortes, die Informationen über empfangbare Sender, Programmsignale und/oder Programmsparten bei einem Wechsel in ein benachbartes Teilgebiet sehr schnell und sicher dem Benutzer zur Auswahl bereitgestellt werden. Der Benutzer wird entweder generell oder auf Wunsch sehr frühzeitig darauf aufmerksam gemacht, ob z. B. das gerade empfangene Programm bei einem vorauszusehenden Wechsel in ein benachbartes Teilgebiet noch empfangbar ist oder nicht. Er kann dann neu auswählen oder etwa mit der Prioritätswahl einer Programmsparte dafür sorgen, daß er zumindest immer ein Programm aus der gewählten Sparte empfängt.

Bei einer vorzugsweise annähernd schachbrettartigen Aufteilung des Empfangsgebietes in Teilgebiete gibt es zu jedem Teilgebiet acht angrenzende Nachbarteilgebiete. Bei einem Fortschreiten des Empfangsortes entlang der Diagonalen in einem Teilgebietsquadrat sind im Speicher folglich jeweils fünf B-Listen zu löschen und hinzuzufügen. Bei einer Richtungsänderung des Empfangsortes parallel zu den Teilgebietsbegrenzungen sind es sogar nur zweimal drei B-Listen, die geändert werden müssen, was zudem schnell durchführbar ist.

Von Vorteil ist weiterhin, daß die B-Listen vorzugsweise aus Folgen von (Programm/sparten)Nummern, jede etwa durch eine 16-Bit-Adresse dargestellt, bestehen und folglich erstens vom Empfänger schnell einlesbar sind und wegen dem geringen Speicherbedarf den Einsatz eines RAM-Speichers für die Speicherung der lokalen B-Liste und/oder der B-Listen der angrenzenden Teilgebiete gestatten.

Die Erfindung ermöglicht durch die Verwendung lokaler B-Listen und deren Verknüpfung mit der Liste A die Ausnutzung von Vorabinformationen, um damit dem Benutzer die empfangbaren Sender, Programmsignale und/oder Programmsparten schneller zur Auswahl anzuzeigen und ihm weiter eine hohe Sicherheit für den Empfang des ausgewählten Programmes oder der ausgewählten Programmsparte zu gewährleisten. Dies zeigt sich etwa darin, daß der Speicherbedarf einiger B-Listen in einer Größenordnung bleibt, so daß im Empfänger nicht nur die aktuelle B-Liste sondern auch die B-Listen der benachbarten Teilgebiete in kommerziell erhältlichen Speicherbausteinen speicherbar sind.

Die Erfindung wird nachstehend anhand von Ausführungsbeispielen unter Bezugnahme auf die Zeichnungen näher beschrieben. Es zeigen:
- Fig. 1:: Landkartenausschnitt
- Fig. 2:: Ausschnitte aus einer Liste A und einer Folge von B-Listen mit zugeordneten Nummern
- Fig. 3:: Formatierung einer Liste B
- Fig. 4:: Empfänger

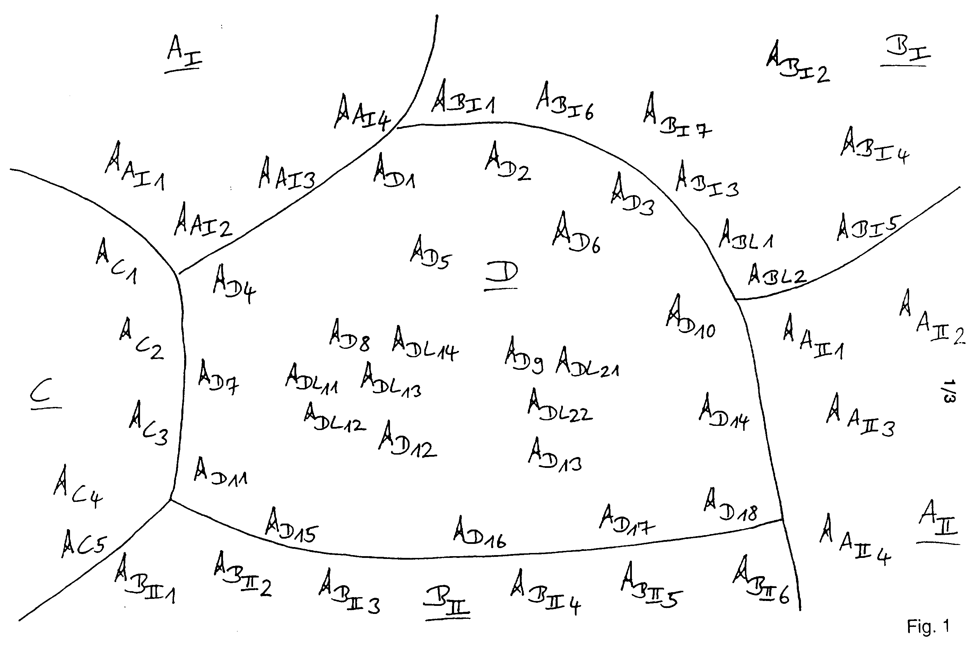

Fig. 1 zeigt einen Ausschnitt aus einer Landkarte, in welche die Grenzen eines Versorgungsbereiches D vollständig und die Grenzen der benachbarten Versorgungsbereiche A_{I}, B_{I}, C, A_{II,} und B_{II,} teilweise eingetragen sind. Die einzelnen Sender sind in Fig. 1 durch tiefgestellte Nummern rechts neben dem Symbol des Versorgungsbereichs gekennzeichnet. Die Lokal- bzw. Regionalsender sind zur Unterscheidung mit dem Index L versehen. Die Versorgungsbereiche werden jeweils durch ein oder mehrere Gleichwellennetze flächendeckend versorgt. Die Gebiete A_{I} und A_{II} sowie B_{I,} und B_{II,} sind soweit räumlich voneinander getrennt, daß den Gebieten A_{I} und A_{II} bzw. B_{I,} und B_{II} jeweils dieselben Senderfrequenzen zugeteilt werden können, ohne gegenseitige Störungen befürchten zu müssen. Die für Lokal- und Regionalsender in einem Sendegebiet festgelegten Frequenzen stimmen bei geringer Senderleistung vorzugsweise mit Frequenzen der Nachbargebiete überein, bei zu großer Sendeleistung werden von den Nachbargebieten verschiedene Frequenzen genommen.

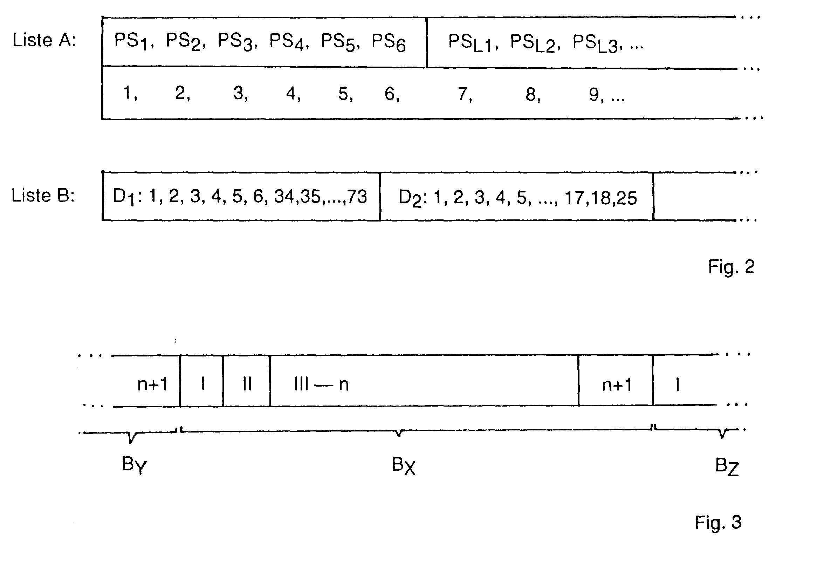

Die im Gleichwellennetz des Versorgungsgebietes D als Liste A übertragenen Daten enthalten die Programminformation PI und Programmsparte PS, wie sie etwa im RDS-System vorliegen, aller empfangbaren Sender. In dieser Liste sind auch die Programmkennungen derjenigen Programme enthalten, die an den Grenzen des Sendegebietes von den Nachbargebieten ausgestrahlt werden und empfangbar sind sowie die Kennungen aller empfangbaren Lokal- und Regionalsender. Des weiteren werden in der Liste A Informationen über empfangbare Sender, Programmsignale und/oder Programmsparten, welche in anderen Frequenzbereichen, Kanälen oder Frequenzblöcken empfangbar sind, übertragen. Alle Kennungen der Liste A sind fortlaufend mit natürlichen Zahlen nummeriert (Fig. 2). Im Gleichwellensendernetz werden die für die Umgebung der einzelnen Sender gültigen Programmkennungen in einzelnen Listen übertragen, die lediglich aus Nummernfolgen der Nummern der Liste A bestehen. Fig. 2 zeigt den Anfang der Liste A, beginnend mit den Programmsparten PS₁, PS_{2,} usw. des Senders D₁ im Versorgungsgebiet D. Danach folgen die Programmsparten der Lokalsender und die Programmkennungen der übrigen Sender. Beginnend mit der Programmsparte PS₁ des Senders D₁ sind den Programmkennungen die natürlichen Zahlen in aufsteigender Reihenfolge beginnend mit der 1 zugeordnet. Unterhalb des Ausschnitts aus der Liste A ist in Fig. 2 der Anfang der B-Listen-Folge in symbolischer Form wiedergegeben. Zuerst wird die Kennung für einen Sender aufgeführt, hier D₁, anschließend folgen die Nummern derjenigen Programmkennungen aus der Liste A, deren Programme an den Orten in der Umgebung des Senders D₁ empfangbar sind. Danach folgt in der Folge der B-Listen eine analoge Aufzählung für den Sender D₂, usw.

Eine lokale Liste B ist aus einer festen Anzahl von Bytes entsprechend Fig. 3 aufgebaut. Nach einem Startwort im Byte I folgt im Byte II die Information, für welchen Sender X des Gleichwellennetzes die nachfolgende Nummernliste von Programmkennungen gültig ist. In den Bytes III bis n sind die Nummern der für den Sender X gültigen Programmkennungen entsprechend der Zuordnung zur Liste A aufgelistet Anschließend folgt das Kennungsende einer B-Liste im Byte n+1. Durch Aneinandereihung solch formatierter B-Listen entsteht eine B-Listen-Folge, von der in Fig. 3 nur die Endkennung n+1 der B-Liste B_{Y} des Senders Y, die gesamte B-Liste B_{X} des Senders X und das erste Byte I der B-Liste B_{Z} des Senders Z dargestellt sind.

Mit Hilfe der an einem Empfangsort empfangbaren Senderstandortkennung des nächstgelegenen Senders des Gleichwellennetzes wählt der Empfänger zunächst die für den Empfangsort gültige Liste B aus. Mit dieser Liste B werden dann aus der Liste A die für den aktuellen Empfangsort gültigen Programmkennungen ausgewählt und in einem Speicher für die Ausgabe auf einer Anzeige bereitgehalten.

Für einen Empfangsort nahe Sender D₅ sind nur die Programme des Gleichwellennetzes D empfangbar. Für einen Empfangsort nahe Sender D₁ sind die Programme der Sendernetze D, A_{I} und B_{I} empfangbar. Für einen Empfangsort nahe Sender D₈ sind die Programme des Sendernetzes D sowie der Lokalsender DL₁₁, DL₁₂, DL₁₃ und DL₁₄ empfangbar. Für einen Empfangsort nahe Sender D₁₀ sind die Programme der Sendernetze D, B_{I}, A_{II} sowie die Programme der Lokalsender BL₁ und BL₂ empfangbar. Für einen Empfangsort nahe Sender D₁₆ sind die Programme der Sendernetze D und B_{II} empfangbar.

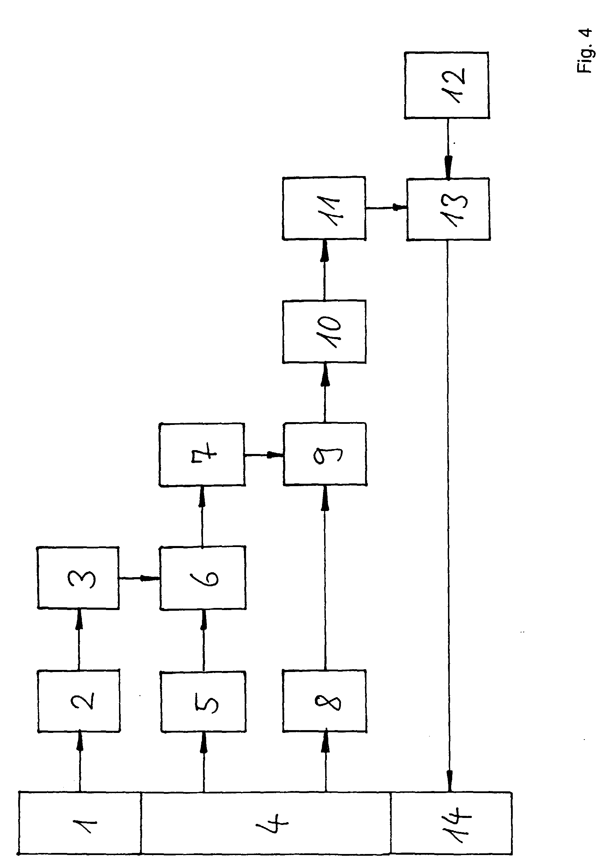

Die Arbeitsweise eines Empfängers zur Durchführung einer ersten Ausführungsform des erfindungsgemäßen Verfahrens wird im folgenden anhand Fig. 4 erläutert.

Der Empfänger enthält ein erstes Empfangsteil (1) zum Empfang und zur Decodierung der Senderstandortkennung. In der mit dem Empfangsteil (1) verbundenen Stufe (2) wird zunächst die Senderstandortkennung des gegenwärtig empfangenen Senders ausgewertet. Diese Kennung wird einem Speicher (3) zugeführt und dort gespeichert.

Ein weiteres Empfangsteil (4) des Empfängers empfängt die Informationen über die Listen B und die Liste A. In der Stufe (5), die mit dem Empfangsteil (4) verbunden ist, werden speziell die Informationen ausgelesen, welche die B-Listen enthalten. In einer Auswahlstufe (6) wird die für den aktuellen Empfangsort gültige Liste B nach Maßgabe der vorliegenden Senderstandortkennung oder Standortinformation ausgewählt und in einer weiteren Stufe (7) gespeichert.

Diejenigen mit dem Empfangsteil (4) empfangenen Informationen, welche die Programmkennungen und ihre Nummerierung enthalten (Liste A), werden in der Stufe (8) ausgelesen. Mit den im Speicher (7) enthaltenen Informationen über die für den aktuellen Empfangsort gültige Liste B werden in der Stufe (9) aus der eingelesenen Liste A die für den Empfangsort gültigen Programmkennungen ausgewählt und in dem Speicher (10) abgelegt. Von diesem Speicher werden die Programmkennungen einer Anzeigevorrichtung (11), die etwa als Display oder als Sprachausgabe ausgebildet ist, zugeführt, wo sie dem Benutzer bzw. Hörer auf Abruf zur Verfügung stehen.

Die Anzeige auf einem Display oder die Sprachausgabe der am Empfangsort empfangbaren Programme wird durch eine Eingabe des Benutzers in die Stufe (12) ausgelöst, etwa durch Drücken einer Taste "Aufrufen". Die empfangbaren Programme erscheinen dann nacheinander mit ausreichender Standzeit (z. B. 3 Sekunden) auf dem Display. Falls der Hörer zu einem der angezeigten Programme wechseln möchte, kann er durch Drücken der Taste "Neuwahl" in der Stufe (12) den Wechsel zu dem gerade angezeigten Programm im Empfänger veranlassen. Die Programmkennung, die jeweils gerade in der Anzeige erscheint, wird einer weiteren Stufe (13) übermittelt. Bei Drücken der Taste "Neuwahl" wird die (ausgewählte) Programmkennung dem Empfänger in einem Empfangsteil (14) übermittelt, der das entsprechende Programm aufschaltet.

Bei einem Programmwechsel und/oder einer Änderung der Senderstandortkennung bzw. des Empfangsortes wird der gesamte zuvor beschriebene Prozeß neu ausgelöst und die Speicher mit den neuen Inhalten überschrieben.

Bei einer zweiten Ausführungsform eines Empfängers zur Durchführung der erfindungsgemäßen Verfahrens werden bei Anwahl einer bestimmten Programmsparte nur die Programme zur Auswahl am Display angezeigt, welche in die angewählte Sparte fallen.

In einem weiteren Ausführungsbeispiel wird im Empfänger anstelle der Standortkennung des empfangenen Senders ein anderes allgemein bekanntes und zugängliches Verfahren zur Ermittlung des aktuellen Standortes bzw. Empfangsortes, wie z. B. ein Verfahren zur Satellitennavigation oder andere Verkehrs-Navigationssysteme, verwendet. Die damit ermittelten Koordinaten des aktuellen Empfangsortes werden im Speicher (3) gespeichert und dazu verwendet die für den aktuellen Empfangsort gültige B-Liste auszuwählen.

## Patentansprüche

1. Verfahren zur Ermittlung und Bereitstellung von Funksignalen und Informationen über am aktuellen Empfangsort empfangbare Funksignale unter Verwendung von Ortsinformationen in einem Rundfunksystem, bei weichem Empfangsorte in einem Empfangsgebiet von einem oder mehreren Sendern versorgt werden,
**dadurch gekennzeichnet,**
daß zur Ermittlung der Informationen über am aktuellen Empfangsort empfangbare Funksignale erste Listen (A) verwendet werden, die Informationen über die in einem, von einem oder mehreren Sendern versorgten, Empfangsgebiet prinzipiell empfangbaren Funksignale enthalten, wobei in den Listen (A) den Informationen über von jeweils einem Sender ausgestrahlten Funksignalen ein oder mehrere Zeichen zugeordnet werden, und daß zur Auswahl aller am aktuellen Empfangsort empfangbaren Funksignale und Informationen über diese Funksignale aus den ersten Listen (A) zweite lokale Listen (B) verwendet werden, die für jeweils ein Teilgebiet des Empfangsgebietes die den Informationen über die in dem jeweiligen Teilgebiet empfangbaren Funksignale zugeordneten Zeichen enthalten, und daß aufgrund der bereitgestellten Informationen ein vom Benutzer aus allen am aktuellen Empfangsort empfangbaren Funksignalen ausgewähltes Funksignal unmittelbar bereitgestellt wird.

2. Verfahren nach Anspruch 1,
**dadurch gekennzeichnet**
daß die Ortskoordinaten des aktuellen Empfangsortes ermittelt und als Ortsinformation verwendet werden.

3. Verfahren nach einem der Ansprüche 1 oder 2,
**dadurch gekennzeichnet,**
daß die Informationen über am aktuellen Empfangsort sicher empfangbare Funksignale ermittelt werden.

4. Verfahren nach einem der Ansprüche 1 bis 3,
**dadurch gekennzeichnet,**
daß die Informationen, welche Funksignale innerhalb eines von einem oder mehreren Sendern versorgten Empfangsgebietes prinzipiell empfangbar sind, von den Sendern ausgestrahlt werden.

5. Verfahren nach einem der Ansprüche 1 bis 4,
**dadurch gekennzeichnet,**
daß die Informationen, welche Funksignale innerhalb eines von einem oder mehreren Sendern versorgten Empfangsgebietes prinzipiell empfangbar sind, im Empfänger gespeichert werden.

6. Verfahren nach Anspruch 5,
**dadurch gekennzeichnet,**
daß bei Änderungen der innerhalb eines von einem oder mehreren Sendern versorgten Empfangsgebietes prinzipiell empfangbaren Funksignale nur diejenigen im Empfänger gespeicherten Informationen ausgetauscht werden, die von den Änderungen betroffen sind.

7. Verfahren nach einem der Ansprüche 1 bis 6,
**dadurch gekennzeichnet,**
daß die Informationen, welche Funksignale der Listen (A) abhängig vom aktuellen Empfangsort empfangbar sind (Listen B), von den Sendern ausgestrahlt werden.

8. Verfahren nach einem der Ansprüche 1 bis 7,
**dadurch gekennzeichnet,**
daß die Informationen, welche Funksignale der Listen (A) abhängig vom aktuellen Empfangsort empfangbar sind (Listen B), im Empfänger gespeichert werden.

9. Verfahren nach einem der Ansprüche 1 bis 8,
**dadurch gekennzeichnet,**
daß bei einem Wechsel des Empfangsortes nur diejenigen der am aktuellen Empfangsort nun geltenden Informationen im Speicher ausgetauscht werden, die sich von den Informationen, welche am vorangegangenen Empfangsort Gültigkeit hatten, unterscheiden.

10. Verfahren nach einem der Ansprüche 1 bis 9,
**dadurch gekennzeichnet,**
daß die Informationen, welche Funksignale innerhalb eines von einem oder mehreren Sendern versorgten Empfangsgebietes prinzipiell empfangbar sind (Listen A), in einem Übertragungszyklus nur einmal aktualisiert werden, hingegen die jeweils gültigen Informationen, welche Funksignale der Listen (A) abhängig vom aktuellen Empfangsort empfangbar sind (Listen B), öfter aktualisiert werden.

11. Verfahren nach einem der Ansprüche 1 bis 10,
**dadurch gekennzeichnet,**
daß die lokalen Listen (B), die für jeweils ein Teilgebiet des Empfangsgebietes die den Informationen über die in dem jeweiligen Teilgebiet empfangbaren Funksignale zugeordneten Zeichen enthalten, zu einer einzigen Liste zusammengesetzt werden.

12. Verfahren nach einem der Ansprüche 1 bis 11,
**dadurch gekennzeichnet,**
daß mit einer Ortsinformation über den aktuellen Empfangsort aus den lokalen Listen (B) die für den aktuellen Empangsort gültige lokale Liste (B) bestimmt wird und damit aus den Listen (A) die Informationen über alle am aktuellen Empfangsort empfangbaren Funksignale ausgewählt werden.

13. Verfahren nach einem der Ansprüche 1 bis 12,
**dadurch gekennzeichnet,**
daß den Informationen, welche Funksignale innerhalb eines von einem oder mehreren Sendern versorgten Empfangsgebietes prinzipiell empfangbar sind (Listen A), einzelne Nummern als Zeichen zugeordnet werden, und daß die lokalen Listen (B) aus Folgen dieser Nummern zusammengesetzt werden.

14. Verfahren nach Anspruch 13,
**dadurch gekennzeichnet,**
daß die Informationen, welche Funksignale innerhalb eines von einem oder mehreren Sendern versorgten Empfangsgebietes prinzipiell empfangbar sind (Listen A), zusammen mit den zugeordneten Nummern von den Sendern ausgestrahlt und/oder im Empfänger gespeichert werden.

15. Verfahren nach einem der Ansprüche 13 oder 14
**dadurch gekennzeichnet,**
daß die Informationen, welche Funksignale der Liste (A) abhängig vom aktuellen Empfangsort empfangbar sind (Listen B), in Form von Nummernfolgen von den Sendern ausgestrahlt und/oder im Empfänger gespeichert werden.

16. Verfahren nach einem der Ansprüche 1 bis 15,
**dadurch gekennzeichnet,**
daß die Informationen, welche Funksignale innerhalb eines von einem oder mehreren Sendern versorgten Empfangsgebietes prinzipiell empfangbar sind (Listen A), sowie die Informationen, welche Funksignale der Listen (A) abhängig vom aktuellen Empfangsort empfangbar sind (Listen B), nicht nur das gegenwärtig empfangene Frequenzband oder den gegenwärtig empfangenen Kanal oder Frequenzblock umfassen, sondern auch andere Frequenzbänder, Kanäle oder Frequenzblöcke.

17. Verfahren nach einem der Ansprüche 1 bis 16,
**dadurch gekennzeichnet,**
daß zur zumindest näherungsweisen Bestimmung des aktuellen Empfangsortes von den Sendern ausgestrahlte Kennungen über die Senderstandorte verwendet und/oder ein Phasenvergleichs-Hyperbelverfahren eingesetzt wird.

18. Verfahren nach einem der Ansprüche 1 bis 17,
**dadurch gekennzeichnet,**
daß zur Ermittlung des aktuellen Empfangsortes ein Verfahren gemäß der Satellitennavigation verwendet wird.

19. Verfahren nach einem der Ansprüche 1 bis 18,
**dadurch gekennzeichnet,**
daß innerhalb eines einer lokalen Liste (B) zugeordneten Teilgebietes des von einem oder mehreren Sendern versorgten Empfangsgebietes an jedem Ort dieselben empfangbaren Funksignale empfangbar sind.

20. Verfahren nach Anspruch 19,
**dadurch gekennzeichnet,**
daß für einen aktuellen Empfangsort in einem Teilgebiet die Informationen über Funksignale (Listen B), die in diesem Teilgebiet und in den angrenzenden Teilgebieten empfangbar sind, von den Sendern ausgestrahlt und/oder im Empfänger am aktuellen Empfangsort gespeichert werden.

21. Verfahren nach Anspruch 20,
**dadurch gekennzeichnet,**
daß bei einem Wechsel zu einem Empfangsort in einem benachbarten Teilgebiet die Informationen über empfangbare Funksignale (Listen B) in den neu hinzugekommenen Teilgebieten im Speicher aufgenommen werden und die Informationen über empfangbare Funksignale in den Teilgebieten, die bezüglich des neuen Empfangsortes keine Nachbarteilgebiete mehr sind, im Speicher gelöscht werden.

22. Verfahren nach einem der Ansprüche 1 bis 21,
**dadurch gekennzeichnet,**
daß für einen schnelleren Austausch der Informationen im Speicher eine Fahrtrichtungsinformation als Vorabinformation noch vor dem Erreichen des neuen Empfangsortes herangezogen wird.

23. Verfahren nach einem der Ansprüche 1 bis 22,
**dadurch gekennzeichnet,**
daß in einem Rundfunksystem, insbesondere in einem Gleichwellensystem, die Funksignalezumindest die empfangbaren Programmsignale und/oder Programmsparten und/oder Sender umfassen.

24. Verfahren nach einem der Ansprüche 1 bis 23,
**dadurch gekennzeichnet,**
daß die Informationen über die in einem, von einem oder mehreren Sendern versorgten, Empfangsgebiet prinzipiell empfangbaren Funksignale in einer einzigen Liste (A) zusammengefaßt und verwendet werden.

25. Empfänger zur Ermittlung und Bereitstellung von Funksignalen und Informationen über am aktuellen Empfangsort empfangbare Funksignale unter Verwendung von Ortsinformationen in einem Rundfunksystem, bei welchem Empfangsorte in einem Empfangsgebiet von einem oder mehreren Sendern versorgt werden,
**dadurch gekennzeichnet,**
daß zur Ermittlung der Informationen über am aktuellen Empfangsort empfangbare Funksignale der Empfänger Mittel zur Ermittlung von Informationen über die in einem, von einem oder mehreren Sendern versorgten, Empfangsgebiet prinzipiell empfangbaren Funksignale und zur Bildung diese Informationen enthaltenden ersten Listen (A) enthält, wobei in den Listen (A) den Informationen über die von jeweils einem Sender ausgestrahlten Funksignale ein oder mehrere Zeichen zugeordnet sind,
daß ferner der Empfänger eine Schaltungseinheit zur automatischen und/oder benutzergesteuerten Bestimmung einer Ortsinformation über den aktuellen Empfangsort aufweist,
daß im Empfänger ein erster Speicher vorhanden ist, in dem zweite lokale Listen (B), die für jeweils ein Teilgebiet des Empfangsgebietes die den Informationen über die in dem jeweiligen Teilgebiet empfangbaren Funksignale zugeordneten Zeichen enthalten, speicherbar sind,
daß der Empfänger eine Steuerungseinheit aufweist, wobei die Steuerungseinheit mit der Ortsinformation und den Informationen (Listen B) aus dem ersten Speicher alle für den aktuellen Empfangsort gültigen Informationen über empfangbare Funksignale aus den Listen (A) auswählt, und daß durch eine zum Empfänger gehörende Ausgabeeinheit diese für den aktuellen Empfangsort gültigen Informationen der Listen (A) einem Benutzer zur Auswahl zur Verfügung stehen.

26. Empfänger nach Anspruch 25,
**dadurch gekennzeichnet,**
daß die Steuerungseinheit mit der Ortinformation aus den Listen (B) die für den aktuellen Empfangsort gültige lokale Liste (B) bestimmt und mit dieser gültigen lokalen Liste (B) die für den aktuellen Empfangsort gültigen Informationen über empfangbare Funksignale aus den Listen (A) auswählt.

27. Empfänger nach einem der Ansprüche 25 bis 26,
**dadurch gekennzeichnet,**
daß der Speicher als RAM-Speicher ausgebildet ist.

28. Empfänger nach einem der Ansprüche 25 bis 27,
**dadurch gekennzeichnet,**
daß der Empfänger eine Antenneneinrichtung und/oder einen weiteren Speicher enthält, um die Informationen über Funksignale, welche innerhalb eines von einem oder mehreren Sendern versorgten Empfangsgebietes prinzipiell empfangbar sind (Listen A), mit der Antenneneinrichtung zu empfangen und/oder von dem weiteren Speicher, insbesondere einem Massenspeicher, einzulesen.

29. Empfänger nach einem der Ansprüche 25 bis 28,
**dadurch gekennzeichnet,**
daß die Ausgabeeinheit vom Benutzer steuerbar ist und als optische Anzeige und/oder als akustische Ansage realisiert ist.

## Claims

1. Method of finding and providing radio signals and information about radio signals receivable at the current receiving point, using location information in a broadcasting system, in which receiving points are supplied in a reception area of one or more transmitters,
**characterised in that,**
to detect the information about radio signals receivable at the current receiving point, first lists (A) are used, which contain information about the radio signals which can in principle be received in a reception area supplied by one or more transmitters, one or more characters being allocated in lists (A) to the information about radio signals emitted by respectively one transmitter, and in that to select all the radio signals receivable at the currrent receiving point and information about these radio signals from the first lists (A) , second local lists (B) are used which contain for respectively a partial region of the reception area the characters allocated to the information about the radio signals receivable in the respective partial area, and on the basis of the information made available, a radio signal is provided directly selected by the user from all the radio signals receivable at the current receiving point.

2. Method according to claim 1, **characterised in that** the location co-ordinates of the current receiving point are detected and used as location information.

3. Method according to one of claims 1 or 2, **characterised in that** the information about radio signals which can be reliably received at the current receiving point is detected.

4. Method according to one of claims 1 to 3, **characterised in that** the information about which radio signals can in principle be received within a reception area supplied by one or more transmitters is emitted by the transmitters.

5. Method according to one of claims 1 to 4, **characterised in that** the information about which radio signals can in principle be received within a reception area supplied by one or more transmitters is stored in the receiver.

6. Method according to claim 5, **characterised in that** when there are changes in the radio signals which can in principle be received within a reception area supplied by one or more transmitters, only that information stored in the receiver is exchanged which is affected by the changes.

7. Method according to one of claims 1 to 6, **characterised in that** the information about which radio signals of lists (A) can be received independently of the current receiving point (lists B) is emitted by the transmitters.

8. Method according to one of claims 1 to 7, **characterised in that** the information about which radio signals of lists (A) can be received independently of the current receiving point (lists B) is stored in the receiver.

9. Method according to one of claims 1 to 8, **characterised in that** when there is a change of receiving point, only the information valid at the current receiving point is exchanged in the memory, which is different from the information which was valid at the previous receiving point.

10. Method according to one of claims 1 to 9, **characterised in that** the information about which radio signals can in principle be received within a reception area supplied by one or more transmitters (lists A), is only updated once in a transmission cycle; on the other hand, the respectively valid information about which radio signals of lists (A) can be received independently of the current receiving point (lists B) is updated more frequently.

11. Method according to one of claims 1 to 10, **characterised in that** the local lists (B), which contain, for respectively a partial region of the reception area the characters allocated to the information about the radio signals receivable in the respective partial region are put together to form a single list.

12. Method according to one of claims 1 to 11, **characterised in that** with a location information about the current receiving point from the local lists (B), the local list (B) valid for the current receiving point is determined, and thus the information about all the radio signals receivable at the current receiving point is selected from lists (A).

13. Method according to one of claims 1 to 12, **characterised in that** individual numbers are allocated as characters to the information about which radio signals can in principle be received within a reception area supplied by one or more transmitters (lists A) , and in that the local lists (B) are composed of sequences of these numbers.

14. Method according to claim 13, **characterised in that** the information about which radio signals can in principle be received within a reception area supplied by one or more transmitters (lists A), are transmitted by the transmitters and/or stored in the receiver together with the associated numbers.

15. Method according to one of claims 13 or 14, **characterised in that** the information about which radio signals of list (A) can be received independently of the current receiving point (lists B) is transmitted by the senders and/or stored in the receiver in the form of number sequences.

16. Method according to one of claims 1 to 15, **characterised in that** the information about which radio signals can in principle be received within a reception area supplied by one or more transmitters (lists A), as well as the information about which radio signals of the lists (A) can be received independently of the current receiving point (lists B), includes not only the currently received frequency band or the currently received channel or frequency block but also other frequency bands, channels or frequency blocks.

17. Method according to one of claims 1 to 16, **characterised in that**, to determine at least approximately the current receiving point, identifications of the transmitter locations emitted by the transmitters are used and/or a phase monitoring hyperbolic system.

18. Method according to one of claims 1 to 17, **characterised in that,** to determine the current receiving point, a method in accordance with satellite navigation is used.

19. Method according to one of claims 1 to 18, **characterised in that** within a partial region, allocated to a local list (B), of the reception area supplied by one or more transmitters, the same receivable radio signals can be received at each point.

20. Method according to claim 19, **characterised in that** for a current receiving point in a partial area, the information about radio signals (lists B), which can be received in this partial area and in the adjoining partial areas, is emitted by the transmitters and/or stored in the receiver at the current receiving point.

21. Method according to claim 20, **characterised in that** when there is a change to a receiving point in an adjacent partial region, the information about receivable radio signals (lists B) in the newly added partial regions is received in the memory and the information about receivable radio signals in the partial regions which are no longer neighbouring regions in respect of the new receiving point, is deleted in the memory.

22. Method according to one of claims 1 to 21, **characterised in that** for a quicker exchange of the information in the memory, information about the direction of motion is used as preliminary information even before the new receiving point has been reached.

23. Method according to one of claims 1 to 22, **characterised in that** in a broadcasting system, especially in a common-wave system, the radio signals include at least the receivable programme signals and/or programme areas and/or transmitters.

24. Method according to one of claims 1 to 23, **characterised in that** the information about the radio signals which can in principle be received in a reception area supplied by one or more transmitters, is summarised and used in a single list (A).

25. Receiver for finding and providing radio signals and information about radio signals receivable at the current receiving point, using location information in a broadcasting system, in which receiving points are supplied in a reception area by one or more transmitters,
**characterised in that**
to detect the information about radio signals receivable at the current receiving point, the receiver contains means for detecting information about the radio signals which can in principle be received in a reception area supplied by one or more transmitters, and means for forming these first lists (A) containing this information, one or more characters being allocated in lists (A) to the information about the radio signals transmitted by respectively one transmitter,
in that furthermore the receiver has a switching unit for the automatic or user-controlled determination of a location information about the current receiving point,
in that there is present in the receiver a first memory, in which second local lists (B) which contain for respectively a partial region of the reception area the characters allocated to the information about the radio signals receivable in the respective partial area, may be stored,
in that the receiver has a control unit, the control unit selecting with the location information and the information (lists B) from the first memory all the information about receivable radio signals valid for the current receiving point from lists (A), and in that through an output unit included in the receiver, this information of the lists (A) valid for the current receiving point is available for a user to select.

26. Receiver according to claim 25, **characterised in that** the control unit determines the local list (B) valid for the current receiving point with the location information from lists (B), and selects with this valid local list (B) the information valid for the current receiving point about receivable radio signals from lists (A).

27. Receiver according to one of claims 25 to 26, **characterised in that** the memory is configured as an RAM memory.

28. Receiver according to one of claims 25 to 27, **characterised in that** the receiver contains an antenna device and/or an additional memory, in order to receive with the antenna device the information about radio signals which can in principle be received within a reception area supplied by one or more transmitters (lists A), and/or to read in from the additional memory, especially a mass memory.

29. Receiver according to one of claims 25 to 28, **characterised in that** the output unit is controllable by the user and is realised as an optical display and/or an audible announcement.

## Revendications

1. Procédé pour déterminer et fournir des signaux radio et des informations concernant des signaux radio susceptibles d'être reçus dans un lieu de réception actuel en utilisant des informations de lieu dans un système radio, selon lequel les lieux de réception sont alimentés, dans une zone de réception par un ou plusieurs émetteurs,
caractérisé en ce que
• pour déterminer les informations concernant les signaux radio susceptibles d'être reçus dans le lieu de réception actuel, on utilise une première liste A contenant des informations concernant les signaux radio en principe susceptible d'être reçu dans la zone de réception alimentée par un ou plusieurs émetteurs, et
• dans la liste A, un ou plusieurs signes concernant chaque fois des signaux radio émis par un émetteur sont associés aux informations, et
• pour la sélection de tous les signaux radio susceptibles d'être reçus dans le lieu de réception actuel, et des informations concernant ces signaux radio de la première liste A, on utilise des secondes listes locales B qui contiennent pour chaque zone partielle de la zone de réception, les signes associés aux informations concernant les signaux radio susceptibles d'être reçus dans la zone partielle respective, et
• à partir des informations fournies, on prépare un signal radio sélectionné par l'utilisateur à partir de tous les signaux radio actuels, reçus dans le lieu de réception actuel.

2. Procédé selon la revendication 1,
caractérisé en qu'
on détermine les coordonnées du lieu de réception actuel et on les utilise comme des informations de lieu.

3. Procédé selon l'une quelconque des revendications 1 ou 2,
caractérisé en ce qu'
on détermine les informations concernant les signaux radio susceptibles d'être reçus en sécurité dans le lieu de réception actuel.

4. Procédé selon l'une quelconque des revendications 1 à 3,
caractérisé en ce que
les émetteurs émettent les informations correspondant à des signaux radio susceptibles d'être reçus en principe dans la zone de réception alimentée par un ou plusieurs émetteurs.

5. Procédé selon l'une quelconque des revendications 1 à 4,
caractérisé en ce que
les informations correspondant à des signaux radio d'une zone de réception alimentée par un ou plusieurs émetteurs, sont mémorisées dans le récepteur.

6. Procédé selon la revendication 5,
caractérisé en ce qu'
en cas de variation des signaux radio reçus en principe dans la zone de réception alimentée par un ou plusieurs émetteurs, on échange seulement les informations mémorisées dans le récepteur et qui sont modifiées.

7. Procédé selon l'une quelconque des revendications 1 à 6,
caractérisé en ce que
les émetteurs émettent les informations susceptibles d'être reçues (liste B) pour des signaux radio de la liste A dépendant du lieu de réception actuel.

8. Procédé selon l'une quelconque des revendications 1 à 7,
caractérisé en ce que
le récepteur mémorise les informations dont les signaux radio de la liste A peuvent être reçus (liste B) en fonction du lieu de réception actuel.

9. Procédé selon l'une quelconque des revendications 1 à 8,
caractérisé en ce que
en cas de changement du lieu de réception, on échange dans la mémoire les seules informations valables maintenant dans le lieu de réception actuel qui se distinguent des informations qui étaient valides dans le lieu de réception précédent.

10. Procédé selon l'une quelconque des revendications 1 à 9,
caractérisé en ce que
les informations qui sont en principe susceptibles d'être reçues (liste A) avec des signaux radio à l'intérieur d'une zone de réception alimentée par un ou plusieurs émetteurs, ne sont actualisées qu'une seule fois dans un cycle de transmission, alors que les informations toujours valables, qui sont des signaux radio de la liste A susceptibles d'être reçus dans le lieu de réception actuel (liste B), sont actualisées plus fréquemment.

11. Procédé selon l'une quelconque des revendications 1 à 10,
caractérisé en ce que
les listes locales B contenant, pour chaque fois une zone partielle de la zone de réception, les signes associés aux informations concernant les signes radio susceptibles d'être reçus dans la zone partielle respective, sont combinées en une liste unique.

12. Procédé selon l'une quelconque des revendications 1 à 11,
caractérisé en ce qu'
avec une information de lieu concernant le lieu de réception actuel, à partir des listes locales B, on définit la liste locale B valable pour le lieu de réception actuel et ainsi, à partir de la liste A, on sélectionne les informations concernant les signaux radio susceptibles d'être reçus dans le lieu de réception actuel.

13. Procédé selon l'une quelconque des revendications 1 à 12,
caractérisé en ce qu'
• aux informations qui sont des signaux radio susceptibles d'être reçus en principe à l'intérieur d'une zone de réception alimentée par un ou plusieurs émetteurs (liste A), on associe différents numéros comme des signes et,
• on réunit les listes locales B à partir des suites de ces numéros.

14. Procédé selon la revendication 13,
caractérisé en ce que
les informations qui sont des signaux radio en principe susceptibles d'être reçus à l'intérieur d'une zone de réception alimentée par un ou plusieurs émetteurs (listes A) sont émises par les émetteurs avec les numéros associés et/ou sont mémorisées dans les récepteurs.

15. Procédé selon l'une quelconque des revendications 13 ou 14,
caractérisé en ce que
les informations qui sont susceptibles d'être reçues comme signaux radio de la liste A en fonction du lieu actuel de réception (listes B), sont émises sous la forme de suites de numéros par les émetteurs et/ou sont mémorisées dans le récepteur.

16. Procédé selon l'une quelconque des revendications 1 à 15,
caractérisé en ce que
les informations qui sont des signaux radio susceptibles d'être reçus en principe à l'intérieur d'une zone de réception alimentée par un ou plusieurs émetteurs (listes A) ainsi que les informations qui sont des signaux radio des listes A, susceptibles d'être reçus à l'emplacement de réception actuel (listes B), comprennent non seulement la bande de fréquences reçue actuellement ou le canal ou le bloc de fréquences reçu actuellement, mais également d'autres bandes de fréquences, canaux ou blocs de fréquences.

17. Procédé selon l'une quelconque des revendications 1 à 16,
caractérisé en ce qu'
au moins approximativement, pour la détermination du lieu de réception actuel par les caractéristiques émises par les émetteurs, on utilise les emplacements des émetteurs et/ou un procédé de comparaison hyperbolique des phases.

18. Procédé selon l'une quelconque des revendications 1 à 17,
caractérisé en ce que
pour déterminer le lieu de réception actuel, on utilise un procédé de navigation par satellite.

19. Procédé selon l'une quelconque des revendications 1 à 18,
caractérisé en ce qu'
à l'intérieur d'une zone partielle associée à une liste locale B dans la zone de réception alimentée par un ou plusieurs émetteurs, on peut recevoir dans chaque lieu les mêmes signaux radio.

20. Procédé selon l'une quelconque des revendications 1 à 19,
caractérisé en ce que
pour le lieu de réception actuel, dans une zone partielle, on émet par les émetteurs et/ou on mémorise dans le lieu de réception actuel, dans le récepteur, les informations concernant les signaux radio (listes B) qui sont susceptibles d'être reçues dans cette zone partielle ou dans les zones partielles adjacentes.

21. Procédé selon la revendication 20,
caractérisé en ce qu'
en cas de changement vers un lieu de réception situé dans une zone partielle voisine, on enregistre dans la mémoire les informations concernant les signaux radio susceptibles d'être reçus (listes B) dans les nouvelles zones partielles rajoutées, et on efface les informations concernant les signaux radio susceptibles d'être reçus dans les zones partielles qui ne sont plus des zones voisines par rapport au nouveau lieu de réception.

22. Procédé selon l'une quelconque des revendications 1 à 21,
caractérisé en ce que
pour un échange plus rapide des informations dans la mémoire, on utilise la direction de déplacement comme information préalable avant même d'atteindre le nouveau lieu de réception.

23. Procédé selon l'une quelconque des revendications 1 à 22,
caractérisé en ce que
dans un système radio, notamment dans un système à ondes continues, les signaux radio comprennent au moins les signaux de programmes susceptibles d'être reçus et/ou les plages de programmes et/ou les émetteurs.

24. Procédé selon l'une quelconque des revendications 1 à 23,
caractérisé en en ce qu'
on regroupe dans une seule liste A les informations concernant les signaux radio susceptibles d'être reçus dans une zone de réception alimentée par un ou plusieurs émetteurs, et on les utilise ainsi.

25. Récepteur pour déterminer et fournir des signaux radio et des informations concernant les signaux radio susceptibles d'être reçus dans le lieu de réception actuel en utilisant des informations de lieu dans un système radio dans lequel les lieux de réception dans une zone de réception sont alimentés par un ou plusieurs émetteurs,
caractérisé en ce que
• pour déterminer les informations concernant les signaux radio susceptibles d'être reçus dans le lieu de réception actuel, le récepteur comporte des moyens pour déterminer les informations concernant les signaux radio susceptibles de n'être reçus en principe que dans une zone de réception alimentée par un ou plusieurs émetteurs, et pour former les premières listes A contenant ces informations et, dans les listes A, un ou plusieurs signes concernant les signaux radio émis chaque fois par un émetteur sont associés aux informations,
• de plus, le récepteur comporte une unité de commutation pour déterminer automatiquement et/ou de manière commandée par l'utilisateur, une information de lieu concernant le lieu de réception actuel, et
• dans le récepteur, une première mémoire peut mémoriser les secondes listes locales B contenant, pour chaque zone partielle de la zone de réception, les signes associés aux informations concernant les signaux radio susceptibles d'être reçus dans zone partielle respective,
• le récepteur comporte une unité de commande qui sélectionne avec l'information de lieu et les informations (listes B) de la première mémoire, toutes les informations valables pour tous les signaux radio des listes A qui sont susceptibles d'être reçus dans le lieu de réception actuel et
• par une unité d'émission faisant partie du récepteur, on fournit à l'utilisateur ces informations valables pour le lieu de réception actuel dans la liste A, de façon qu'elles soient sélectionnées.

26. Récepteur selon la revendication 26,
caractérisé en ce qu'
avec l'information de lieu, à partir des listes B, l'unité de commande définit la liste locale B valable pour le lieu de réception actuel, et, avec cette liste locale valable B, on sélectionne les informations valables pour le lieu de réception actuel à partir de signaux radio susceptibles d'être reçus, en partant des listes A.

27. Récepteur selon l'une quelconque des revendications 25 à 26,
caractérisé en ce que
les mémoires sont des mémoires vives (RAM).

28. Récepteur selon l'une quelconque des revendications 25 à 27,
caractérisé en ce que
le récepteur comporte une installation d'antenne et/ou une autre mémoire pour enregistrer les informations concernant les signaux radio susceptibles d'être reçus en principe (listes A) dans une zone de réception alimentée par un ou plusieurs émetteurs, avec une installation d'antenne pour la réception et/ou une autre mémoire, notamment une mémoire de masse.

29. Récepteur selon l'une quelconque des revendications 25 à 28,
caractérisé en ce que
l'unité d'émission est commandée par l'utilisateur et est réalisée comme moyen d'affichage optique et/ou comme moyen d'information acoustique.
